# DEMANDE DE BREVET EUROPEEN

(11) **EP 4 618 328 A1**
(43) Date de publication de la demande: **17.09.2025**
(21) Numéro de dépôt: 25163254.3
(22) Date de dépôt: 12.03.2025
(51) Int. Cl.: H02B 1/30, H01H 71/04, H01H 9/16

(54) **SYSTÈME DE SURVEILLANCE, ENSEMBLE DE RÉPARTITION, PROCÉDÉ DE SURVEILLANCE ET PROGRAMME D'ORDINATEUR ASSOCIÉS**

(30) Priorité: 13.03.2024 FR 2402505
(71) Demandeur: SCHNEIDER ELECTRIC INDUSTRIES SAS, 92500 Rueil-Malmaison (FR)
(72) Inventeur: AGNAOU, Abderrahmane, 38100 Grenoble (FR); DOUCET, Emmanuel, 38130 Échirolles (FR); GOUPIL, Laurent, 38110 La Tour-du-Pin (FR); CRISANTI, Marta, 38000 Grenoble (FR)
(74) Mandataire: Lavoix

(57) **Abrégé**

La présente invention concerne un système de surveillance d'une armoire électrique apte à être connectée entre une source électrique (3) et une pluralité de charges (5), l'armoire électrique (10) comprenant une pluralité de dispositifs de commutation (20), chaque dispositif comprenant un organe mobile (22) configurée pour se déplacer lorsqu'un défaut électrique est détecté par le dispositif ou suite à une commande d'un utilisateur, chaque dispositif étant d'un type parmi le groupe consistant en : un type disjoncteur et un type autre que disjoncteur, le système comprenant au moins un radar (32), configuré pour, lorsque l'un des organes mobiles se déplace, émettre un signal de sortie représentatif d'une vitesse de déplacement de l'organe mobile ainsi que d'une course de l'organe mobile ; et un module électronique de contrôle, configuré pour recevoir le signal de sortie et déterminer le type du dispositif auquel appartient l'organe mobile associé au signal de sortie.

## Description

La présente invention concerne un système de surveillance, un ensemble de répartition, un procédé de surveillance et un programme d'ordinateur associé.

Il est connu de surveiller un état armé ou déclenché de certains dispositifs de commutation, compris dans une armoire électrique, notamment des disjoncteurs, afin de faciliter une intervention sur l'armoire électrique lorsqu'un défaut électrique est détecté. Pour cela, il est connu de rajouter un module dit OFSD, pour Ouvert Fermé Système Défaut, aux dispositifs à surveiller. Cependant, un module OFSD doit être ajouté par dispositif à surveiller, ce qui augmente les coûts de l'armoire électrique, et l'installation d'un tel module OFSD nécessite des câblages supplémentaires, ce qui rend leur installation complexe. De plus, dans de nombreux cas, l'espace dans l'armoire électrique est insuffisant pour installer les modules OFSD sur les dispositifs de commutation à surveiller.

Il est également connu de surveiller un état armé ou déclenché de dispositifs dans des armoires électriques via des ondes électromagnétiques, par exemple dans DE102012110246A1. D'autres systèmes de surveillance sont décrits dans CA2783227A1, EP3731251A1, US6020821A1 et EP3920204A1.

Le but de l'invention est alors de proposer un système de surveillance d'une armoire électrique qui soit plus facile d'installation, moins couteux et qui nécessite moins d'espace que les solutions existantes.

A cet effet, l'invention a pour objet un système de surveillance d'une armoire électrique, l'armoire électrique étant apte à être connectée entre une source électrique et une pluralité de charges, l'armoire électrique comprenant une pluralité de dispositifs de commutation, chaque dispositif comprenant un organe mobile configuré pour se déplacer lorsqu'un défaut électrique est détecté par le dispositif ou suite à une commande d'un utilisateur, chaque dispositif étant d'un type parmi le groupe consistant en : un type disjoncteur et un type autre que disjoncteur, le système comprenant :
- au moins un radar, configuré pour, lorsque l'un des organes mobiles se déplace, émettre un signal de sortie qui est représentatif d'une vitesse de déplacement de l'organe mobile ainsi que d'une course de l'organe mobile ;
- un module électronique de contrôle, configuré pour recevoir le signal de sortie et déterminer le type du dispositif auquel appartient l'organe mobile associé au signal de sortie, et
un module d'émission, configuré pour émettre un message représentatif du type déterminé par le module électronique de contrôle.

Grâce à l'invention, il est possible de surveiller plusieurs dispositifs de commutation avec un unique système de surveillance, par l'utilisation d'au moins un radar, qui est capable de détecter un déplacement d'un organe mobile dans une zone suffisament étendue pour que plusieurs dispositifs de commutation soient surveillés simultanément. Le module de détermination assure une distinction entre les dispositifs de type disjoncteurs, et les dispositifs de type autre que disjoncteur, ce qui évite les fausses alertes en cas de déplacement d'un organe mobile appartenant à un dispositif de type autre que disjoncteur, autrement dit, en cas de déclenchement d'un dispositif de type autre que disjoncteur.

Le système de surveillance de l'invention est simple d'installation, puisqu'il ne nécessite pas d'être connecté à chaque dispositif de commutation à surveiller, et, pour un nombre de dispositifs de commutations à surveiller équivalent, prend moins de place que les dispositifs de surveillance connus. De plus, il peut être ajouté une fois l'armoire électrique déjà en service, sans modifier l'agencement des appareils inclus dans l'armoire.

Suivant d'autres aspects avantageux de l'invention, le système comprend une ou plusieurs des caractéristiques suivantes, prises isolément ou suivant toutes les combinaisons techniquement possibles :
- Le module électronique de contrôle comprend :
- une unité de calcul configurée pour calculer, à partir du signal de sortie, la vitesse de déplacement et la course de l'organe mobile associé au signal de sortie ; et
- une unité de détermination, configurée pour déterminer le type du dispositif auquel appartient l'organe mobile associé au signal de sortie à partir de la vitesse de déplacement et de la course calculées par l'unité de calcul.
- Le module électronique de contrôle comprend :
- une unité de calcul configurée pour calculer une métrique à partir du signal de sortie ; et
- une unité de détermination, configurée pour déterminer le type du dispositif auquel appartient l'organe mobile associé au signal de sortie via un modèle d'intelligence artificielle, la métrique étant une variable d'entrée du modèle, le type du dispositif auquel appartient l'organe mobile associé au signal de sortie étant une variable de sortie du modèle.
- Le modèle d'intelligence artificielle est un réseau de neurones ou une forêt aléatoire.
- Le signal de sortie étant représentatif en outre d'une position à l'intérieur de l'armoire du dispositif comprenant l'organe mobile associé au signal de sortie.
- Chaque dispositif de type disjoncteur comprenant un sous-type, le module électronique de contrôle étant en outre configuré, lorsqu'un organe mobile appartenant à un dispositif de type disjoncteur se déplace, pour déterminer le sous-type du dispositif auquel appartient l'organe mobile associé au signal de sortie.

L'invention concerne également un ensemble de répartition d'un courant électrique entre une source et une charge, l'ensemble comprenant :
- une armoire électrique comprenant une enveloppe, l'enveloppe comprenant deux parois longitudinales s'étendant parallèlement à un axe de hauteur, alignées l'une par rapport à l'autre selon un axe de largeur, et une pluralité de dispositifs de commutation, chaque dispositif comprenant un organe mobile configurée pour se déplacer lorsqu'un défaut électrique est détecté par le dispositif ou suite à une commande d'un utilisateur, chaque dispositif étant d'un type parmi le groupe consistant en : un type disjoncteur et un type autre que disjoncteur, la pluralité de dispositifs étant localisée entre les parois longitudinales selon l'axe de largeur ; et
- le système de surveillance décrit précédemment, l'au moins un radar étant fixé sur l'enveloppe.

Suivant d'autres aspects avantageux de l'invention, l'ensemble de répartition comprend une ou plusieurs des caractéristiques suivantes, prises isolément ou suivant toutes les combinaisons techniquement possibles :
- L'au moins un radar est fixé sur l'une des parois longitudinales de l'armoire électrique.
- L'enveloppe comprend une porte, qui, lorsqu'elle est fermée, recouvre les parois longitudinales et les dispositifs de protection, et dans lequel l'au moins un radar est fixé sur la porte.

L'invention concerne également un procédé de surveillance d'une armoire électrique l'armoire électrique comprenant une pluralité de dispositifs de commutation, chaque dispositif comprenant un organe mobile configuré pour se déplacer lorsqu'un défaut électrique est détecté par le dispositif ou suite à une commande d'un utilisateur, chaque dispositif étant d'un type parmi le groupe consistant en : un type disjoncteur et un type autre que disjoncteur, le procédé de surveillance étant mis en œuvre par un système de surveillance décrit précédemment, le procédé comprenant les étapes suivantes :
- lorsque l'un des organes mobiles se déplace, émission par l'un des au moins un radars d'un signal de sortie représentatif d'une vitesse de déplacement de l'organe mobile ainsi que d'une course de l'organe mobile ;
- réception du signal de sortie par le module électronique de contrôle ;
- détermination du type du dispositif auquel appartient l'organe mobile associé au signal de sortie par le module électronique de contrôle ; et
- émission d'un message représentatif du type du dispositif auquel appartient l'organe mobile associé au signal de sortie, par le module d'émission.

L'invention concerne également un programme d'ordinateur comportant des instructions logicielles qui, lorsqu'elles sont exécutées par un ordinateur, mettent en œuvre un procédé de surveillance tel que défini ci-dessus.

L'invention apparaîtra plus clairement à la lecture de la description qui va suivre, donnée uniquement à titre d'exemple non limitatif, et faite en référence aux dessins dans lesquels :
- [Fig. 1] la figure 1 est une représentation schématique d'un ensemble de répartition d'un courant électrique selon un premier mode de réalisation de l'invention ;
- [Fig. 2] la figure 2 est une représentation schématique d'un ensemble de répartition selon un deuxième mode de réalisation de l'invention ;
- [Fig. 3] la figure 3 est une représentation schématique d'un système de surveillance selon le premier mode de réalisation de l'invention ;
- [Fig. 4] la figure 4 est une représentation graphique de types et de sous-types de dispositifs de commutation ;
- [Fig. 5] la figure 5 est un logigramme d'un procédé de surveillance selon l'invention ; et
- [Fig. 6] la figure 6 est une représentation schématique d'un système de surveillance selon un troisième mode de réalisation de l'invention.

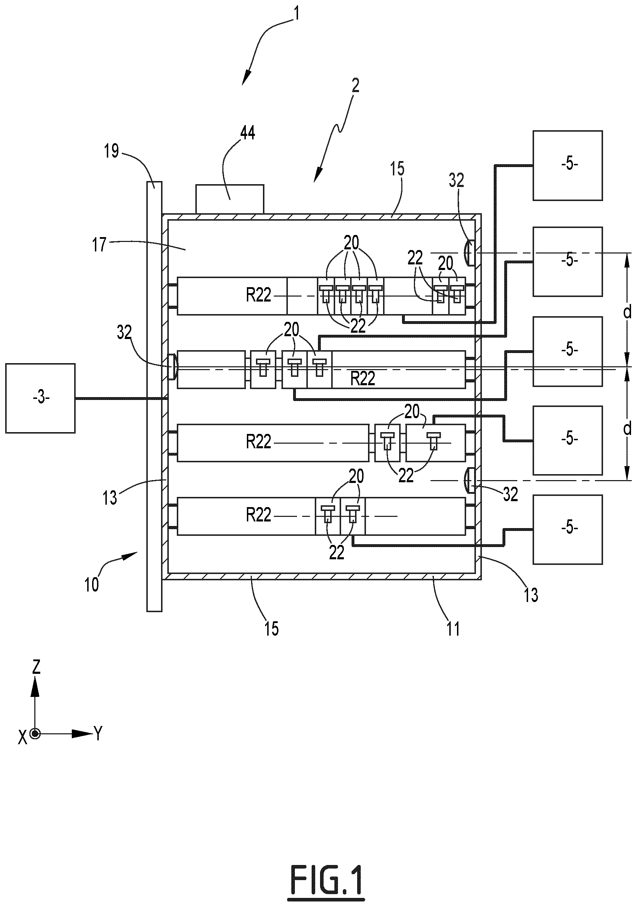

La figure 1 est une représentation schématique d'un circuit 1 comprenant un ensemble de répartition 2 d'un courant électrique entre une source 3 et une pluralité de charges 5, l'ensemble de répartition 2 étant destiné à être connecté à la source 3 et à la pluralité de charges 5.

La source 3 est par exemple un transformateur moyenne tension ou un transformateur moyenne tension vers basse tension. De manière alternative, la source 3 est un autre système de répartition d'un courant électrique. La source électrique 3 est apte à fournir un courant électrique à l'ensemble de répartition 2 qui est configuré pour le répartir entre les charges 5.

Les charges 5 consomment le courant électrique fourni par la source 3. De préférence, les charges 5 sont des dispositifs électriques tels que l'arrêt de leur fonctionnement de manière imprévue n'engendre pas de dommages ou de risque pour la sécurité d'usagers des charges 5. Les charges 5 sont par exemple utilisés pour améliorer le confort des usagers, et sont par exemple des dispositifs d'éclairage.

L'ensemble de répartition 2 comprend une armoire électrique 10, aussi dite simplement armoire. L'armoire électrique 10 est située par exemple à l'intérieur d'un bâtiment et repose par exemple sur un sol.

L'armoire électrique 10 comprend une enveloppe 11, à l'intérieur de laquelle sont disposés la plupart de ses composants. L'enveloppe 11 est par exemple en forme d'un coffret, non représenté, apte à être totalement fermé. L'enveloppe 11 comporte deux parois longitudinales 13, s'étendant parallèlement à un axe de hauteur Z. Les parois longitudinales 13 sont alignées l'une par rapport à l'autre selon un axe de largeur Y. L'enveloppe 11 comprend également deux parois transversales 15, s'étendant parallèlement à l'axe de largeur Y, et reliant les parois longitudinales 13 entre elles. L'enveloppe 11 comprend en outre un fond 17, solidaire mécaniquement aux parois longitudinales 13 et transversales 15, et une porte 19, alignée avec le fond selon un axe de profondeur X. La porte 19 forme généralement une porte amovible, ou encore une porte mobile par rapport aux parois longitudinales 13 et transversales 15 entre une configuration fermée dans laquelle la porte 19 recouvre les parois longitudinales 13, ainsi qu'un espace délimité par les parois longitudinales 13 et transversales 15, et une configuration ouverte permettant d'avoir accès aux composants disposés à l'intérieur de l'enveloppe, dans l'espace délimité par les parois longitudinales 13 et transversales 15.

L'armoire électrique 10 est configurée pour répartir le courant électrique depuis la source 3 vers la pluralité de charges 5. En particulier, l'armoire électrique 10 est configurée pour interrompre le courant circulant vers la pluralité de charges 5. L'interruption du courant est soit volontaire, c'est-à-dire décidée par un utilisateur de l'armoire électrique 10, ou sur défaut, c'est-à-dire causée par un défaut électrique survenant dans le circuit 1. Les défauts électriques sont des valeurs de tension ou d'intensité électriques anormales dans le circuit 1. Les défauts électriques sont par exemple des surtensions, des surintensités, des courts-circuits, ou encore des défauts de surcharge. Afin d'interrompre le courant circulant de la source 3 vers la pluralité de charges 5, l'armoire électrique 10 comprend une pluralité de dispositifs de commutation 20. Chaque dispositif de commutation 20 est relié à la source 3 et à une charge 5. Les dispositifs 20 sont localisés, entre les parois longitudinales 13 selon l'axe de largeur Y. Plus précisément, les dispositifs 20 sont disposés dans l'espace délimité par les parois longitudinales 13 et transversales 15, autrement dit, à l'intérieur de l'armoire électrique 10. Ainsi, lorsque la porte 19 est fermée, elle recouvre les dispositifs 20. Généralement, les dispositifs 20 sont arrangés à l'intérieur de l'armoire 10 en lignes parallèles à l'axe de largeur Y.

Chaque dispositif 20 est configuré pour basculer entre une configuration armée, dans laquelle il conduit le courant, et une configuration déclenchée, dans laquelle il ne conduit pas le courant, et isole la source 3 et la charge 5 à laquelle il est connecté.

Chaque dispositif 20 comprend un organe mobile 22. Chaque organe mobile 22 est configurée pour se déplacer lorsque le dispositif 20 qui la comprend bascule en configuration déclenchée. En particulier, chaque organe mobile 22 pivote autour d'un axe de rotation R22.

Dans l'exemple de la figure 1, les axes de rotation R22 des organes mobiles 22 sont parallèles à l'axe de largeur Y.

Les dispositifs de commutation 20 sont d'un type parmi le groupe consistant en un type disjoncteur, et un type dit autre que disjoncteur.

Les dispositifs 20 de type disjoncteur sont des dispositifs configurés pour interrompre le courant électrique sur défaut. Les dispositifs 20 de type disjoncteur sont par exemple des disjoncteurs miniatures, ou MCB, de l'anglais « *Miniature Circuit Breaker »,* des disjoncteurs à boîtier moulé, ou MCCB, de l'anglais « *Molded* Case *Circuit Breaker », ou* encore des dispositifs à courant différentiel, ou RCD, de l'anglais « *Residuai Current Device* ». Lorsqu'un défaut électrique est détecté par le dispositif 20 de type disjoncteur, le dispositif 20 bascule en configuration déclenchée et l'organe mobile 22 du dispositif 20 de type disjoncteur se déplace. L'organe mobile 22 d'un dispositif 20 de type disjoncteur est par exemple une manette de commutation, aussi appelé manetton.

Les dispositifs 20 de type autre que disjoncteur sont des dispositifs configurés pour interrompre le courant électrique volontairement. Ils sont configurés pour être pilotés à distance par un utilisateur, par exemple un technicien, et interrompre le courant suite à une commande de l'utilisateur. Les dispositifs 20 de type autre que disjoncteur sont par exemple des télérupteurs ou des contacteurs. Lorsqu'un utilisateur commande l'un des dispositifs 20 de type autre que disjoncteur, le dispositif 20 de type autre que disjoncteur bascule en configuration déclenchée et l'organe mobile 22 du dispositif 20 de type autre que disjoncteur se déplace.

De manière avantageuse, les dispositifs 20 de type disjoncteur comprennent également un sous-type. Le sous-type est par exemple un calibre de puissance, un calibre d'intensité ou une famille. Par calibre de puissance, on entend la puissance que le dispositif 20 de type disjoncteur est apte à supporter sans être endommagée. Par calibre d'intensité, on entend l'intensité maximale que le dispositif 20 de type disjoncteur est apte à supporter sans être endommagée, par exemple moins de 63 A ou plus de 63 A. Par famille, on entend une technologie de coupure du courant circulant dans le dispositif, par exemple une famille de dispositifs à coupure électromécanique, hybride ou à semi-conducteurs.

Les organes mobiles 22 des dispositifs 20 de type disjoncteur et autre que disjoncteur se déplacent selon une vitesse de déplacement Vₘ et une course Dₘ spécifique, représentatives de leur type. De manière avantageuse, la vitesse de déplacement Vₘ et la course Dₘ des organes mobiles 22 des dispositifs 20 de type disjoncteur sont également représentatives de leur sous-type.

L'ensemble de répartition 2 comprend en outre un système de surveillance 30 de l'armoire électrique 10.

Le système de surveillance 30 comprend au moins un radar 32, ici trois radars 32. Le système de surveillance 30 comprend en variante moins de trois radars 32 ou plus de trois radars 32. Chacun des radars 32 est configuré pour émettre un signal de sortie lorsque l'un des organes mobiles de commutation 22 se déplace, comme expliqué plus en détail un peu plus bas.

Les radars 32 sont des dispositifs émetteurs-récepteurs d'ondes électromagnétiques. Par exemple, les radars 32 comprennent un émetteur et un récepteur, ou en variante, un émetteur et deux récepteurs. De manière avantageuse, une fréquence des ondes électromagnétiques émises par les radars 32 est comprise entre 10 et 70 GHz, de préférence comprise entre 20 et 30 GHz, de préférence encore, égale à 24GHz. De manière avantageuse, les radars 32 sont des radars à effet Doppler.

Dans l'exemple de la figure 1, les radars 32 sont fixés sur les parois longitudinales 13, de telle sorte à émettre les ondes électromagnétiques globalement selon l'axe de largeur Y. En variante non représentée, les radars 32 sont tous situés sur la même paroi longitudinale 13.

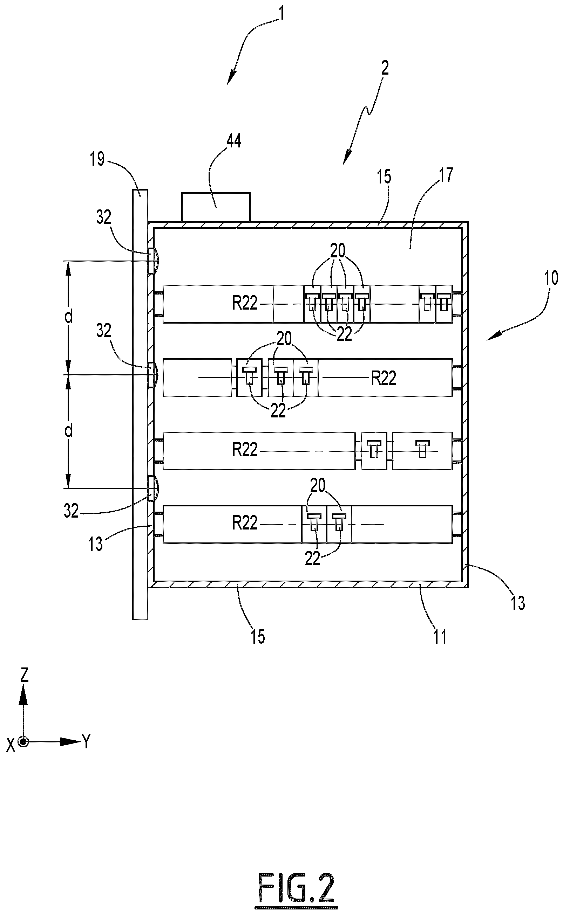

La figure 2 représente un deuxième mode de réalisation de l'ensemble de répartition 2, dans lequel les radars 32 sont fixés sur la porte 19.

En pratique, chaque radar 32 émet en permanence à sa sortie une grandeur physique. Lorsqu'aucun organe mobile 22 ne se déplace, cette grandeur ne comprend aucune information relative aux organes mobiles 22. Lorsqu'un organe mobile 22 se déplace, la grandeur physique émise par au moins un des radars 32 à sa sortie change et forme un signal de sortie qui est alors représentatif d'une vitesse de déplacement Vₘ et d'une course Dₘ de l'organe mobile 22.

De manière particulièrement avantageuse, le signal de sortie est en outre représentatif d'une position à l'intérieur de l'armoire 10 de l'organe mobile 22 associé au signal de sortie, en particulier une position relative entre le ou les radars 32 ayant émis le signal de sortie, et l'organe mobile 22 associé.

De manière particulièrement avantageuse, dans les modes de réalisation des figures 1 et 2, les radars 32 sont séparés les uns des autres d'une distance d selon l'axe de hauteur Z inférieure à 500mm, de préférence inférieure à 400mm, de préférence encore, égale à 300mm. En effet, dans les exemples des figures 1 et 2, un unique radar 32 n'a pas une portée suffisante pour détecter un déplacement de l'ensemble des organes mobiles 22. Plusieurs radars 32 sont alors nécessaires pour détecter un déplacement de l'ensemble des organes mobiles 22 comprises dans l'armoire 10. Ainsi, lorsqu'un organe mobile 22 se déplace, au moins un des radars 32 parmi les radars 32 du système de surveillance 30 émet un signal de sortie qui est représentatif de la vitesse de déplacement Vₘ et de la course Dₘ de l'organe mobile 22. La course Dₘ est également appelée l'amplitude de déplacement de l'organe mobile 22.

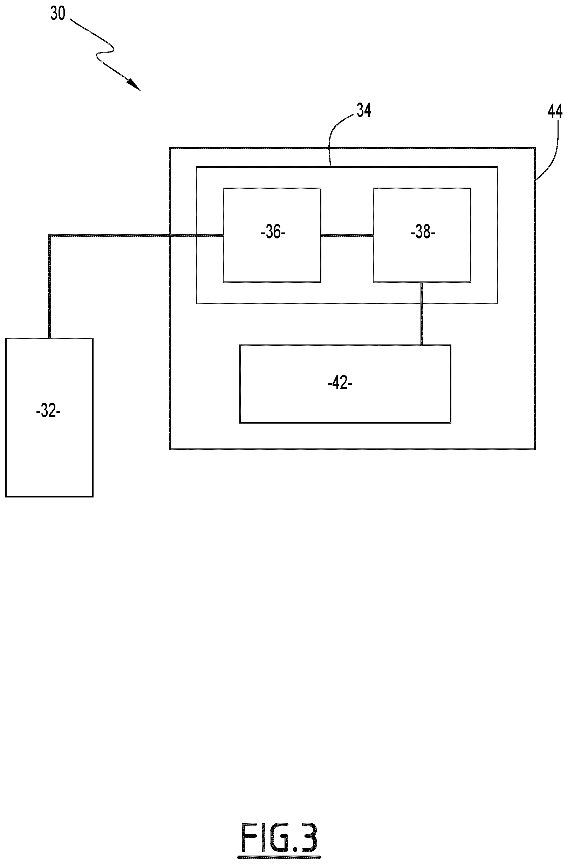

Le système de surveillance 30 comprend en outre un module électronique de contrôle 34, connecté aux radars 32, et visible à la figure 3. Le module électronique de contrôle 34 est avantageusement localisé sur ou à l'intérieur de l'armoire 10, par exemple en étant fixé sur l'enveloppe 11. Dans les exemples des figures 1 et 2, le module électronique de contrôle 34 est fixé sur l'une des parois transversales 15.

Le module électronique de contrôle 34 est configuré pour recevoir le signal de sortie et pour déterminer le type du dispositif 20 auquel appartient l'organe mobile 22 associé au signal de sortie.

A cet effet, le module électronique de contrôle 34 comprend avantageusement une unité de calcul 36. Selon un premier mode de réalisation, l'unité de calcul 36 est configurée pour calculer la vitesse de déplacement et la course de l'organe mobile 22 associé au signal de sortie à partir du signal de sortie. Le module électronique de contrôle 34 comprend de manière avantageuse une unité de détermination 38, configurée pour recevoir la vitesse de déplacement Vₘ et la course Dₘ de l'organe mobile 22 associé au signal de sortie et déterminer, à partir de la vitesse de déplacement Vₘ et la course Dₘ, le type du dispositif 20 auquel appartient l'organe mobile 22 associé au signal de sortie.

De manière particulièrement avantageuse, si l'organe mobile 22 associé au signal de sortie est de type disjoncteur, le module électronique de contrôle 34 est en outre configuré pour déterminer le sous-type du dispositif 20. Dans l'exemple des figures 1 et 3, c'est l'unité de détermination 38 qui est configurée pour déterminer le sous-type du dispositif 20.

Le module électronique de contrôle 34 comprend une unité de traitement d'informations formée par exemple d'une mémoire et d'un processeur associé à la mémoire, non représentés.

Dans l'exemple de la figure 3, l'unité de calcul 36 et l'unité de détermination 38 sont réalisées chacun sous forme d'un logiciel, ou d'une brique logicielle, exécutable par le processeur. La mémoire du module électronique de contrôle 34 est alors apte à stocker un logiciel de calcul et un logiciel de détermination. Le processeur est alors apte à exécuter chacun des logiciels parmi le logiciel de calcul et un logiciel de détermination.

En variante non représentée, l'unité de calcul 36 et l'unité de détermination 38 sont réalisées chacune sous forme d'un composant logique programmable, tel qu'un FPGA, de l'anglais « *Field Programmable Gate Array »,* ou encore d'un circuit intégré, tel qu'un ASIC, de l'anglais *« Application Specific Integrated Circuit ».*

Lorsque le module électronique de contrôle 34 est réalisé sous forme d'un ou plusieurs logiciels, c'est-à-dire sous forme d'un programme d'ordinateur, également appelé produit programme d'ordinateur, il est en outre apte à être enregistré sur un support, non représenté, lisible par ordinateur. Le support lisible par ordinateur est par exemple un medium apte à mémoriser des instructions électroniques et à être couplé à un bus d'un système informatique. A titre d'exemple, le support lisible est un disque optique, un disque magnéto-optique, une mémoire ROM, une mémoire RAM, tout type de mémoire non-volatile (par exemple FLASH ou NVRAM) ou une carte magnétique.

Le système de surveillance 30 comprend en outre un module d'émission 42, configuré pour émettre un message représentatif du type déterminé par le module électronique de contrôle 34, avantageusement par l'unité de détermination 38. Le module d'émission 42 est avantageusement également réalisé sous la forme d'un programme d'ordinateur et, dans ce cas, il est avantageusement apte à être enregistré sur le même support lisible par ordinateur que celui sur lequel le module électronique de contrôle 34 est réalisé. Sur le support lisible est alors mémorisé un programme d'ordinateur comprenant des instructions logicielles qui, lorsqu'elles sont exécutées par un ordinateur, mettent en œuvre un procédé de surveillance décrit en détail par la suite.

De manière avantageuse, le module d'émission 42 est configuré pour envoyer des informations supplémentaires, par exemple, dans le cas d'une détermination que le type du dispositif 20 est disjoncteur, des informations sur la position du dispositif 20 à l'intérieur de l'armoire 10 et/ou sur son sous-type.

De manière avantageuse, et ainsi que représenté sur les figures 1 et 2, le module électronique de contrôle 34 et le module d'émission 42 sont regroupés dans un boîtier 44.

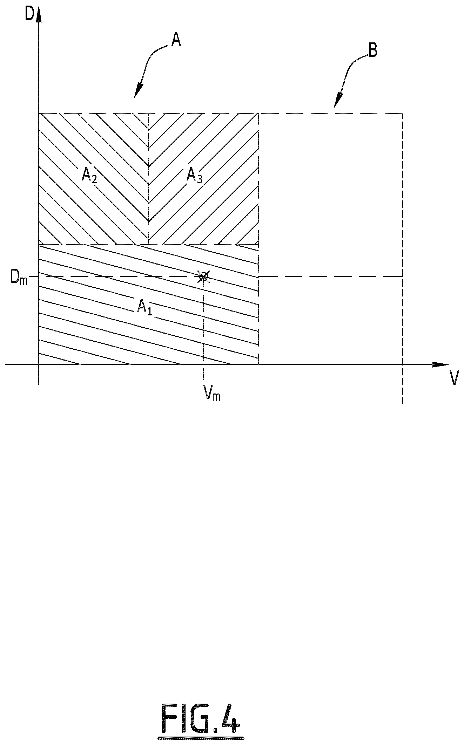

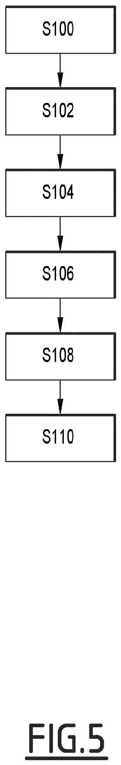

Un procédé de surveillance de l'armoire électrique 10 est décrit, en référence aux figures 4 et 5.

Initialement, l'armoire électrique 10 est dans un état S100, dans lequel aucun organe mobile 22 ne se déplace.

Un organe mobile 22 se déplace à l'étape S102.

Lors de l'étape S104, au moins un des radars 32 émet un signal de sortie représentatif de la vitesse de déplacement Vₘ et de la course Dₘ de l'organe mobile 22.

Le module électronique de contrôle 34 reçoit le signal de sortie lors d'une étape de réception S106.

Lors d'une étape de détermination S108, le module électronique de contrôle 34, ayant reçu le signal de sortie, détermine le type du dispositif 20 auquel appartient l'organe mobile 22 associé au signal de sortie. Pour cela, l'unité de calcul 36 calcule la vitesse de déplacement Vₘ et la course Dₘ de l'organe mobile 22 associé au signal de sortie, et l'unité de détermination 38 reçoit la vitesse de déplacement Vₘ et la course Dₘ de l'organe mobile 22 associé au signal de sortie et détermine le type du dispositif 20 comme étant disjoncteur ou autre que disjoncteur.

Par exemple, l'unité de détermination 38 compare la vitesse de déplacement Vₘ et la course Dₘ de l'organe mobile 22 obtenues par l'unité de calcul 36 à des seuils de vitesse de déplacement et de courses d'organe mobile, prédéfinis à l'avance, par exemple par le constructeur. Ainsi, l'unité de détermination 38 détermine le type du dispositif 20 comprenant l'organe mobile 22 associé au signal de sortie en fonction de la vitesse de déplacement Vₘ et la course Dₘ de l'organe mobile 22 obtenues par l'unité de calcul 36.

Dans l'exemple de la figure 4, les vitesses de déplacement V et courses D correspondant aux dispositifs 20 de type disjoncteur sont symbolisées par la zone A, et les vitesses de déplacement V et courses D correspondant aux dispositifs 20 de type autre que disjoncteur sont symbolisées par la zone B. La vitesse de déplacement Vₘ et la course Dₘ de l'organe mobile 22 associé au signal de sortie correspondent à un dispositif 20 de type disjoncteur. L'unité de détermination 38 détermine donc le type du dispositif 20 comme étant de type disjoncteur.

En variante non représentée, l'unité de détermination 38 compare la vitesse de déplacement Vₘ et la course Dₘ de l'organe mobile 22 obtenues par l'unité de calcul 36 à une base de données de vitesses de déplacement et de courses d'organe mobiles de différents dispositifs 20, et détermine ainsi le type du dispositif 20 comprenant l'organe mobile 22 associé au signal de sortie.

De manière avantageuse, le dispositif 20 comprenant l'organe mobile 22 associé au signal de sortie étant de type disjoncteur, l'unité de détermination 38 détermine le sous-type du dispositif 20 lors d'une étape S108.

Dans l'exemple de la figure 4, les sous-types sont représentés par les zones A₁, A₂ et A₃, correspondant, par exemple respectivement à un RCD, à un MCB et à un MCCB. La vitesse de déplacement Vₘ et la course Dₘ de l'organe mobile 22 associé au signal de sortie correspondent donc à un dispositif 20 de type RCD.

Une fois le type et, avantageusement, le sous type déterminés par l'unité de détermination 38, le module d'émission 42 émet un message représentatif du type de dispositif comprenant l'organe mobile 22 lors d'une étape d'émission S110.

Le message est par exemple un message d'alerte, comprenant un texte indiquant qu'un dispositif 20 de type disjoncteur a été déclenché. Avantageusement, le message comprend des informations sur la position du dispositif 20 à l'intérieur de l'armoire 10 et/ou sur son sous-type, en l'occurrence RCD.

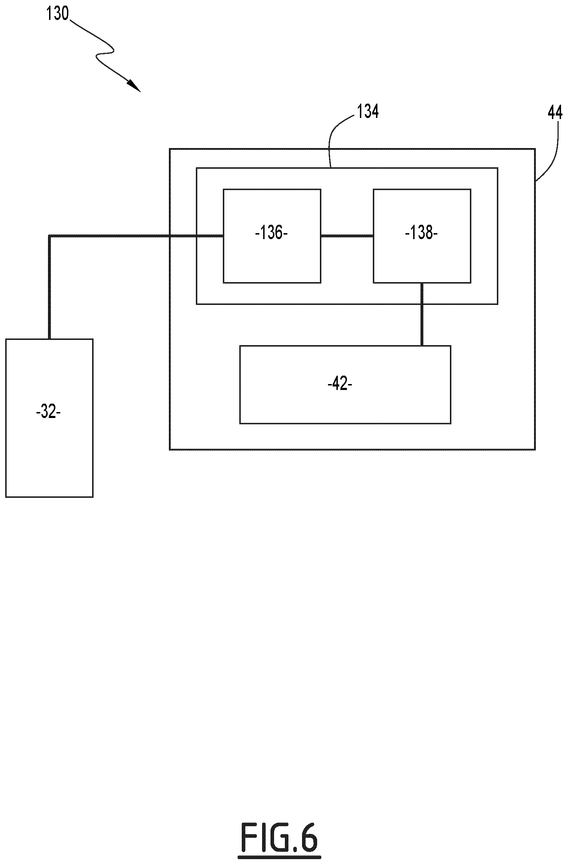

Sur la figure 6 est représenté un système de surveillance 130 en tant que forme de réalisation alternative au système de surveillance 30. Le système de surveillance 130 diffère du système de surveillance 30 par son module électronique de contrôle 134, qui remplace le module électronique de contrôle 34.

Le module électronique de contrôle 134 est connecté aux radars 32, et est configuré pour recevoir le signal de sortie et pour déterminer le type du dispositif 20 auquel appartient l'organe mobile 22 associé au signal de sortie.

Le module électronique de contrôle 134 diffère du module électronique de contrôle 34 en ce qu'il comprend une unité de calcul 136 et une unité de détermination 138, qui remplacent respectivement l'unité de calcul 36 et l'unité de détermination 38.

L'unité de calcul 136 est connectée aux radars 32 et est configuré pour recevoir le signal de sortie, et pour calculer une métrique à partir du signal de sortie. En variante, l'unité de calcul 136 calcule une pluralité de métriques à partir du signal de sortie. Une métrique est une grandeur, ou une série de grandeurs, déduites du signal de sortie, qui permettent de décrire le signal de sortie. Les métriques peuvent être en lien direct avec l'organe mobile 22 associé au signal de sortie, comme c'est le cas pour la vitesse de déplacement et la course, ou non. Par exemple, une métrique sans lien direct avec l'organe mobile 22 associé au signal de sortie est une transformée de Fourier du signal de sortie, une transformée simplifiée ou filtrée, un maximum de la transformée de Fourier, un facteur de forme, des caractéristiques relatives aux pics de la transformée de Fourier, comme leur nombre, localisation, leur largeur. En variante, d'autres métriques sont également utilisées.

L'unité de détermination 138 est connectée à l'unité de calcul 136 et au module d'émission 42. L'unité de détermination 138 est configurée pour recevoir la pluralité de métriques calculées, et pour déterminer le type du dispositif 20 auquel appartient l'organe mobile 22 associé au signal de sortie via un modèle d'intelligence artificielle. La métrique, ou, en variante, la pluralité de métriques calculées par l'unité de calcul 136 sont des variables d'entrée du modèle. Le type du dispositif 20 auquel appartient l'organe mobile 22 associé au signal de sortie est une variable de sortie du modèle.

De manière avantageuse, et de manière similaire à ce qui a été décrit pour l'unité de détermination 38, lorsque l'unité de détermination 138 détermine que le dispositif 20 comprenant l'organe mobile 22 associé au signal de sortie est de type disjoncteur, le modèle d'intelligence artificielle de l'unité de détermination 138 est configuré pour déterminer le sous-type du dispositif 20. Dans ce cas, le sous-type du dispositif 20 est une autre variable de sortie du modèle.

Le modèle d'intelligence artificielle est par exemple une forêt aléatoire, ou un réseau de neurones.

Le réseau de neurones comporte une succession ordonnée de couches de neurones dont chacune prend ses entrées sur les sorties de la couche précédente.

Plus précisément, chaque couche comprend des neurones prenant leurs entrées sur les sorties des neurones de la couche précédente, ou bien sur les variables d'entrée pour la première couche.

En variante, des structures de réseaux de neurones plus complexes peuvent être envisagées avec une couche qui peut être reliée à une couche plus lointaine que la couche immédiatement précédente.

À chaque neurone est également associé une opération, c'est-à-dire un type de traitement, à effectuer par ledit neurone au sein de la couche de traitement correspondante.

Chaque couche est reliée aux autres couches par une pluralité de synapses. Un poids synaptique est associé à chaque synapse, et chaque synapse forme une liaison entre deux neurones. C'est souvent un nombre réel, qui prend des valeurs positives comme négatives. Dans certains cas, le poids synaptique est un nombre complexe.

Chaque neurone est propre à effectuer une somme pondérée des valeurs reçues de la part des neurones de la couche précédente, chaque valeur étant alors multipliée par le poids synaptique respectif de chaque synapse, ou liaison, entre ledit neurone et les neurones de la couche précédente, puis à appliquer une fonction d'activation, typiquement une fonction non-linéaire, à ladite somme pondérée, et à délivrer en sortie dudit neurone, en particulier aux neurones de la couche suivante qui lui sont connectés, la valeur résultant de l'application de la fonction d'activation. La fonction d'activation permet d'introduire une non-linéarité dans le traitement effectué par chaque neurone. La fonction sigmoïde, la fonction tangente hyperbolique, la fonction de Heaviside sont des exemples de fonction d'activation.

En complément facultatif, chaque neurone est également apte à appliquer, en outre, un facteur multiplicatif, également appelé biais, à la sortie de la fonction d'activation, et la valeur délivrée en sortie dudit neurone est alors le produit de la valeur de biais et de la valeur issue de la fonction d'activation.

Le réseau de neurones est par exemple un réseau de neurones à convolution. Un réseau de neurones à convolution est aussi parfois dénommé réseau de neurones convolutif ou par le sigle CNN qui renvoie à la dénomination anglaise de *« Convolutional Neural Networks ».*

Dans un réseau de neurones à convolution, chaque neurone d'une même couche présente exactement le même schéma de connexion que ses neurones voisins, mais à différentes positions d'entrée. Le motif de connexion est appelé noyau de convolution ou, plus souvent, « *kernel »* en référence à la dénomination anglaise correspondante.

Une couche de neurones entièrement connectée est une couche dans laquelle les neurones de ladite couche sont chacun connectés à tous les neurones de la couche précédente.

Un tel type de couche est plus souvent dénommé selon le terme anglais de *« fully connected »,* et parfois désigné sous la dénomination « couche dense ».

Le modèle d'intelligence artificielle est entraîné par le fabriquant, avant la mise en service du système de surveillance 130.

Dans l'exemple de la figure 6, l'unité de calcul 136 et l'unité de détermination 138 sont réalisées chacune sous forme d'un logiciel, ou d'une brique logicielle, exécutable par un processeur non représenté. Une mémoire non représentée du module électronique de contrôle 134 est alors apte à stocker un logiciel de calcul et un logiciel de détermination. Le processeur est alors apte à exécuter chacun des logiciels parmi le logiciel de calcul et le logiciel de détermination.

En variante non représentée, l'unité de calcul 136 et l'unité de détermination 138 sont réalisées chacune sous forme d'un composant logique programmable, tel qu'un FPGA, ou encore d'un circuit intégré, tel qu'un ASIC.

Lorsque le module électronique de contrôle 134 est réalisé sous forme d'un ou de plusieurs logiciels, c'est-à-dire sous forme d'un programme d'ordinateur, également appelé produit programme d'ordinateur, il est en outre apte à être enregistré sur un support, non représenté, lisible par ordinateur. Le support lisible par ordinateur est par exemple un medium apte à mémoriser des instructions électroniques et à être couplé à un bus d'un système informatique. A titre d'exemple, le support lisible est un disque optique, un disque magnéto-optique, une mémoire ROM, une mémoire RAM, tout type de mémoire non-volatile (par exemple FLASH ou NVRAM) ou une carte magnétique. Avantageusement, le module d'émission 42, sous forme de logiciel, est enregistré sur ce même support lisible. Sur le support lisible est alors mémorisé un programme d'ordinateur comprenant des instructions logicielles. Ces instructions logicielles, lorsqu'exécutées par un ordinateur, mettent en œuvre un procédé de surveillance pour le système de surveillance 130, similaire à celui décrit pour le système de surveillance 30, sauf pour les différences décrites ci-après. L'étape S108 est modifiée comme suit. Lors de l'étape S108, le module électronique de contrôle 134, ayant reçu le signal de sortie, détermine le type du dispositif 20 auquel appartient l'organe mobile 22 associé au signal de sortie. Pour cela, l'unité de calcul 136 calcule une métrique, avantageusement plusieurs métriques, qui sont reçues en tant que variables d'entrée par le modèle d'intelligence artificielle de l'unité de détermination 138. Le modèle d'intelligence artificielle détermine ensuite le type disjoncteur ou autre que disjoncteur du dispositif 20 et, avantageusement, le sous-type du dispositif 20.

Selon une variante non représentée, les dispositifs 20 sont disposés en lignes parallèles à l'axe de hauteur Z et les axes de rotation des organes mobiles R22 sont parallèles à l'axe de hauteur Z. Dans ce cas, de manière particulièrement avantageuse, les radars 32 sont disposés sur les parois transversales 15, de telle manière à émettre les ondes électromagnétiques globalement selon l'axe de hauteur Z.

En variante non représentée, l'axe de rotation R22 d'une partie des organes mobiles 22 est parallèle à l'axe de largeur Y et une autre partie des organes mobiles 22 est parallèle à l'axe de hauteur Z.

Toute caractéristique décrite pour un mode de réalisation ou une variante dans ce qui précède peut être mise en œuvre pour les autres modes de réalisation et variantes décrits précédemment, pour autant que techniquement faisable.

## Revendications

1. Système de surveillance (30 ; 130) d'une armoire électrique (10), l'armoire électrique (10) étant apte à être connectée entre une source électrique (3) et une pluralité de charges (5), l'armoire électrique (10) comprenant une pluralité de dispositifs de commutation (20), chaque dispositif (20) comprenant un organe mobile (22) configuré pour se déplacer lorsqu'un défaut électrique est détecté par le dispositif (20) ou suite à une commande d'un utilisateur,
**caractérisé en ce que** chaque dispositif (20) est d'un type parmi le groupe consistant en : un type disjoncteur et un type autre que disjoncteur,
et **en ce que** le système (30) comprend :
- au moins un radar (32), configuré pour, lorsque l'un des organes mobiles (22) se déplace, émettre un signal de sortie qui est représentatif d'une vitesse de déplacement (Vₘ) de l'organe mobile (22) ainsi que d'une course (Dₘ) de l'organe mobile (22) ;
- un module électronique de contrôle (34 ; 134), configuré pour recevoir le signal de sortie et déterminer le type du dispositif (20) auquel appartient l'organe mobile (22) associé au signal de sortie, et
- un module d'émission (42), configuré pour émettre un message représentatif du type déterminé par le module électronique de contrôle (34 ; 134).

2. Système de surveillance (30) selon la revendication 1, dans lequel le module électronique de contrôle (34) comprend :
- une unité de calcul (36) configurée pour calculer, à partir du signal de sortie, la vitesse de déplacement (Vₘ) et la course (Dₘ) de l'organe mobile (22) associé au signal de sortie ; et
- une unité de détermination (38), configurée pour déterminer le type du dispositif (20) auquel appartient l'organe mobile (22) associé au signal de sortie à partir de la vitesse de déplacement (Vₘ) et de la course (Dₘ) calculées par l'unité de calcul (36).

3. Système de surveillance (130) selon la revendication 1, dans lequel le module électronique de contrôle (134) comprend :
- une unité de calcul (136) configurée pour calculer une métrique à partir du signal de sortie ; et
- une unité de détermination (138), configurée pour déterminer le type du dispositif (20) auquel appartient l'organe mobile (22) associé au signal de sortie via un modèle d'intelligence artificielle, la métrique étant une variable d'entrée du modèle, le type du dispositif (20) auquel appartient l'organe mobile (22) qui associé au signal de sortie étant une variable de sortie du modèle.

4. Système de surveillance (130) selon la revendication 3, dans lequel le modèle d'intelligence artificielle est un réseau de neurones ou une forêt aléatoire.

5. Système de surveillance (30 ; 130) selon l'une quelconque des revendications précédentes, le signal de sortie étant représentatif en outre d'une position à l'intérieur de l'armoire (10) du dispositif (20) comprenant l'organe mobile (22) associé au signal de sortie.

6. Système de surveillance (30 ; 130) selon l'une quelconque des revendications précédentes, chaque dispositif (20) de type disjoncteur comprenant un sous-type, le module électronique de contrôle (34 ; 134) étant en outre configuré, lorsqu'un organe mobile (22) appartenant à un dispositif (20) de type disjoncteur se déplace, pour déterminer le sous-type du dispositif (20) auquel appartient l'organe mobile (22) associé au signal de sortie.

7. Ensemble de répartition (2) d'un courant électrique entre une source et une charge, l'ensemble (2) comprenant :
- une armoire électrique (10) comprenant une enveloppe (11), l'enveloppe (11) comprenant deux parois longitudinales (13) s'étendant parallèlement à un axe de hauteur (Z), alignées l'une par rapport à l'autre selon un axe de largeur (Y), et une pluralité de dispositifs de commutation (20), chaque dispositif (20) comprenant un organe mobile (22) configurée pour se déplacer lorsqu'un défaut électrique est détecté par le dispositif (20) ou suite à une commande d'un utilisateur, chaque dispositif (20) étant d'un type parmi le groupe consistant en : un type disjoncteur et un type autre que disjoncteur, la pluralité de dispositifs (20) étant localisée entre les parois longitudinales (13) selon l'axe de largeur (Y) ; et
- le système de surveillance (30 ; 130) selon l'une quelconque des revendications précédentes, l'au moins un radar (32) étant fixé sur l'enveloppe (11).

8. Ensemble de répartition (2) selon la revendication 7, dans lequel l'au moins un radar (32) est fixé sur l'une des parois longitudinales (13) de l'armoire électrique (10).

9. Ensemble de répartition (2) selon la revendication 7, dans lequel l'enveloppe (11) comprend une porte (19), qui, lorsqu'elle est fermée, recouvre les parois longitudinales (13) et les dispositifs de protection (20), et dans lequel l'au moins un radar (32) est fixé sur la porte (19).

10. Procédé de surveillance d'une armoire électrique (10), l'armoire électrique (10) comprenant une pluralité de dispositifs de commutation (20), chaque dispositif (20) comprenant un organe mobile (22) configurée pour se déplacer lorsqu'un défaut électrique est détecté par le dispositif (20) ou suite à une commande d'un utilisateur, chaque dispositif (20) étant d'un type parmi le groupe consistant en : un type disjoncteur et un type autre que disjoncteur, le procédé de surveillance étant mis en œuvre par un système de surveillance (30 ; 130) selon l'une quelconque des revendications 1 à 6, le procédé comprenant les étapes suivantes :
- lorsque l'un des organes mobiles (22) se déplace, émission (S104) par l'un des au moins un radars (32) d'un signal de sortie représentatif d'une vitesse de déplacement (Vₘ) de l'organe mobile (22) ainsi que d'une course (Dₘ) de l'organe mobile (22) ;
- réception (S106) du signal de sortie par le module électronique de contrôle (34 ; 134) ;
- détermination (S108) du type du dispositif (20) auquel appartient l'organe mobile (22) associé au signal de sortie par le module électronique de contrôle (34 ; 134) ; et
- émission (S110) d'un message représentatif du type du dispositif (20) auquel appartient l'organe mobile (22) associé au signal de sortie, par le module d'émission (42).

11. Programme d'ordinateur comportant des instructions logicielles qui, lorsqu'elles sont exécutées par un ordinateur, mettent en œuvre un procédé de surveillance selon la revendication 10.
